Europäisches Patentamt

European Patent Office

Office européen des brevets

(19)

(11) Veröffentlichungsnummer: **0 207 266**
**B1**

(12) # EUROPÄISCHE PATENTSCHRIFT

(45) Veröffentlichungstag der Patentschrift:
21.03.90

(21) Anmeldenummer: 86106541.5

(22) Anmeldetag: 14.05.86

(51) Int. Cl.⁵: **H 01 L 29/14**

(54) Verfahren zur Herstellung einer räumlich periodischen Halbleiter-Schichtenfolge.

(30) Priorität: **17.05.85 DE 3517701**
**31.07.85 DE 3527363**

(43) Veröffentlichungstag der Anmeldung:
**07.01.87 Patentblatt 87/02**

(45) Bekanntmachung des Hinweises auf die Patenterteilung:
**21.03.90 Patentblatt 90/12**

(84) Bennante Vertragsstaaten:
**DE FR GB**

(56) Entgegenhaltungen:
EP-A-0 005 059
EP-A-0 133 342

**Bell Laboratories Record, Band 58, Nr. 8. September 1980, Seiten 274-281; Murray Hill, N.J., US R. DINGLE et al.: "Building semiconductors from the atom up."**

**Applied Physics Letters, Band 45, Nr.11, 1. Dezember 1984, Seiten 1231-1233; Am. Inst. of Physics, New York,US R.PEOPLE et al.:"Modulation doping in GexSil- x/Si strained layer heterostructures."**

**Applied Physics Letters, Band 37, Nr 11, 1. Dezember 1980, Seiten 1033-1035; Am Inst. of Physics, New York, US L.C. Witkowski et al.:" High mobilities in AlxGai-xAs-GaAs heterojunctions."**

(73) Patentinhaber: **Licentia Patent-Verwaltungs-GmbH**
**Theodor-Stern-Kai 1**
**D-6000 Frankfurt/Main 70 (DE)**

(72) Erfinder: **Herzog, Hans J.**
**Stauffenbergstrasse 18**
**D-7910 Neu-Ulm/Pfuhl (DE)**
Erfinder: **Jorke, Helmut**
**Böhmstrasse 76**
**D-7929 Gerstetten (DE)**
Erfinder: **Kibbel, Horst**
**Buchenstrasse 23**
**D-7904 Erbach (DE)**

(74) Vertreter: **Schulze, Harald Rudolf, Dipl.-Ing.**
**Licentia Patent-Verwaltungs-GmbH Theodor-Stern-Kai 1**
**D-6000 Frankfurt/Main 70 (DE)**

## Beschreibung

Die Erfindung betrifft ein Verfahren zur Herstellung einer räumlich periodischen Halbleiter-Schichtenfolge nach dem Oberbegriff des Patentanspruchs 1.

Insbesondere in der Elektroindustrie werden Halbleiterbauelemente benötigt, die eine möglichst kurze Schaltzeit besitzen für einen zu schaltenden elektrischen Strom. Dieses ist einerseits erreichbar durch eine Verkleinerung der entsprechenden geometrischen Strukturen und andererseits durch Verwendung von Halbleitermaterialien, die eine hohe Elektronen-Beweglichkeit besitzen.

Aus der Vorveröffentlichung von H. M. Manasevit et al., Journal of Elektronic Materials, 12, Seite 637 (1983) ist es beispielsweise bekannt, eine Si-SiGe-Schichtenfolge zu erzeugen, die als sogenanntes Supergitter aufgebaut ist und die eine erheblich größere Elektronen-Beweglichkeit besitzt als homogen dotiertes Si-Material.

In der europäischen Patentanmeldung EP-A-0 133 342 wird der Aufbau von Supergittern beschrieben, die aus verschiedenen III/V-, II/VI-Verbindungshalbleiterschichten oder aus Kombinationen von Si- oder Ge-Schichten mit III/V-Verbindungshalbleiterschichten oder aus Si- und Gen oder C-Schichten aufgebaut sind (Seite 12, Zeile 3 bis Seite 13, Zeile 4). Durch die selektive Dotierung von z. B. Si- oder AlGaAs-Schichten tritt keine bleibende räumliche Trennung der Ladungsträger von den Dotierstoffrümpfen auf, sondern aufgrund der sehr dünnen Halbleiterschichten des Supergitters von etwa 0,5 bis 2 nm wird durch Ausnutzen des Tunneleffekts eine Gleichverteilung der Ladungsträger über das gesamte Supergitter erreicht (Anspruch 1). Mit einem derartigen Halbleiteraufbau wird eine möglichst hohe homogene Ladungsdichteverteilung im gesamten Halbleiter erreicht, nicht jedoch eine hohe Beweglichkeit der Ladungsträger in einer bestimmten Halbleiterschicht.

In der europäischen Patentanmeldung EP-A-0 005 059 ist eine Heterostruktur aus einer alternierenden Folge von AlGaAs- und GaAs-Schichten angegeben. Durch Modulationsdotierung der AlGaAs-Schicht, die einen größeren Bandabstand besitzt als die GaAs-Schicht, wird eine Erhöhung der Ladungsträgerbeweglichkeit erreicht, die dadurch zustande kommt, daß durch die Dotierung der Halbleiterschicht mit

Halbleiterschicht mit großem Bandabstand Ladungsträger in die Halbleiterschicht mit kleinem Bandabstand wandern. Die Ladungsträger werden von den Dotierstoffrümpfen getrennt und es wird eine hohe Ladungsträgerbeweglichkeit in der Halbleiterschicht mit geringem Bandabstand erzielt.

In einer Veröffentlichung von R. People et al., Appl. Phys. Lett. 45, S. 1231 bis 1236, (1984) ist ein SiGe/SiSupergitter beschrieben bei dem die Si-Schicht, die einen größeren Bandabstand besitzt als die SiGe-Schicht, mit positiven Ladungsträgern modulationsdotiert wird, um die Ladungsträgerbeweglichkeit zu erhöhen. Eine wesentliche Erhöhung der Ladungsträgerbeweglichkeit gegenüber gleichmäßig dotierten Halbleiterschichten wurden für Temperaturen 100 K festgestellt.

Der Erfindung liegt die Aufgabe zugrunde, ein gattungsgemäßes Verfahren dahingehend zu verbessern, daß eine möglichst hohe Elektronen-Beweglichkeit erreicht wird, insbesondere in Halbleiterschichten, die Silizium enthalten und die sich auf Raumtemperatur (300 K) befinden.

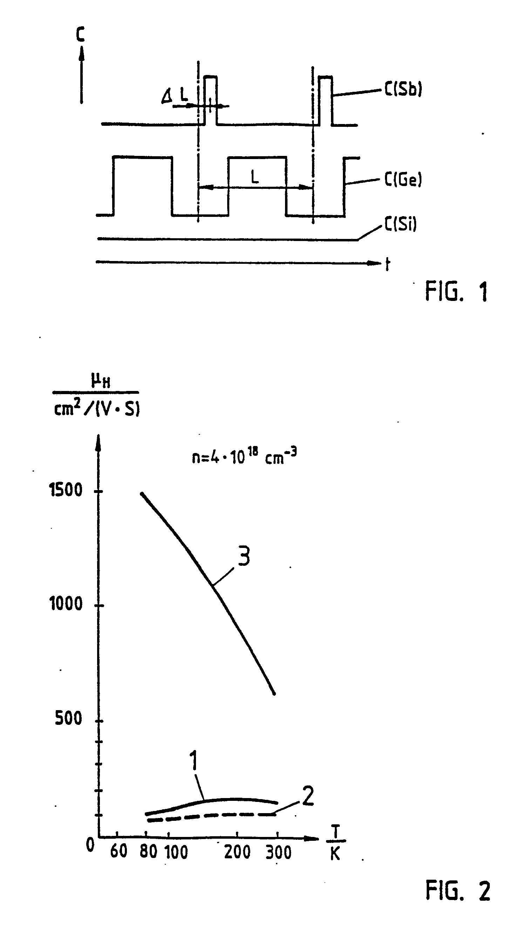

Diese Aufgabe wird gelöst durch die im kennzeichnenden Teil des Patentanspruchs 1 angegebenen Merkmale. Zweckmäßige Ausgestaltungen und/oder Weiterbildungen sind den Unteransprüchen entnehmbar. Die Erfindung wird im folgenden anhand von Ausführungsbeispielen näher erläutert unter Bezugnahme auf die Figuren 1 und 2.

Fig. 1 zeigt ein schematisches Diagramm zur Erläuterung des Dotierungsverlaufes in einer beispielhaften Si-SiGe-Schichtenfolge

Fig. 2 zeigt die Abhängigkeit der Hall-Beweglichkeit $\mu_H$ von der Temperatur T für verschiedene Halbleitermaterialien.

Gemäß Fig. 1 wird zur Herstellung einer beispielhaften Si-SiGe-Halbleiter-Schichtenfolge ein Molekularstrahlepitaxie-Verfahren (MBE-Verfahren) angewandt. Dabei wird während des Wachstums der Halbleiter-Schichtenfolge die Si-Konzentration C(Si) im wesentlichen konstant gehalten. Eine Germanium (Ge)-Quelle wird in Abhängigkeit von der Zeit t periodisch geöffnet und geschlossen, so daß die Ge-Konzentration C(Ge) den dargestellten mäander- oder pulsförmigen Verlauf hat mit der Periodenlänge L. Auf einem beispielhaften Halbleitersubstrat aus ein kristallinen Silizium (Si) mit einer (100)-Kristallorientierung entsteht daher eine alternierende Halbleiter-Schichtenfolge aus Si- und SiGe-Schichten mit einer beispielhaft gewählten Schichtdicke von jeweils 5 nm. Die Konzentrationen C(Si) und C(Ge) sind dabei derart gewählt, daß im wesentlichen reine Si-Schichten und $Si_{0.55}Ge_{0.45}$-Schichten entstehen. Wird nun während dieses Schichten-Wachstums zusätzlich eine Antimon (Sb)-Dotierung zeitlich periodisch eingebaut, so hat die zugehörige Sb-Konzentration C(Sb) beispielsweise den dargestellten pulsförmigen Verlauf. In der Halbleiter-Schichtenfolge entsteht daher eine zusätzlich Sb-dotierte Schicht, deren Schichtdicke kleiner oder gleich ist als diejenige der Halbleiterschicht.

Eine Änderung des sogenannten Dotierungsphasenwinkels $\varphi = 2\pi \cdot \Delta L/L$ ermöglicht beispielsweise, daß entweder lediglich die Si-Schichten Sb-dotiert werden oder lediglich die $Si_{0.55}Ge_{0.45}$-Schichten. Überraschenderweise wurde festgestellt, daß eine Sb-Dotierung lediglich in den $Si_{0.55}Ge_{0.45}$-Schichten zu einer erheblichen Erhöhung der Elektronenbeweglichkeit in dem entstandenen Supergitter führt.

Fig. 2 zeigt die Abhängigkeit der Hall-Beweglichkeit µH der Elektronen von der Temperatur T für verschiedene Halbleitermaterialien. Kurve 1 bezieht sich auf reines Si-Einkristallmaterial, Kurve 2 bezieht sich auf $Si_{0.75}Ge_{0.25}$-Material und Kurve 3 bezieht sich auf ein Si-$Si_{0.55}Ge_{0.45}$-Supergitter mit einer räumlichen Periodenlänge von ungefähr 10 nm und einer Anzahl von 10 Perioden. Bei diesem Supergitter sind lediglich die $Si_{0.55}Ge_{0.45}$-Schichten Sb-dotiert mit einer Flächenkonzentration $n = 4 \cdot 10^{12}$ cm$^{-2}$. Aus Fig. 2 ist ersichtlich, daß die Elektronenbeweglichkeit gemäß Kurve 3 bei Raumtemperatur (300 K) ungefähr viermal größer ist als diejenige gemäß den Kurven 1 und 2. Weiterhin ist es vorteilhafterweise möglich, die Elektronenbeweglichkeit einzustellen durch Änderung des erwähnten Dotierungsphasenwinkels und/oder der Temperatur T.

Es wurde nun in überraschender Weise festgestellt, daß außer der erwähnten Dotierung auch der mechanische Spannungszustand der Halbleiterschichten des Supergitters einen erheblichen Einfluß hat auf die Elektronenbeweglichkeit µH. Dabei ist insbesondere die laterale mechanische Spannung innerhalb der Halbleiterschichten wichtig. Mit lateraler mechanischer Spannung wird diejenige mechanische Spannung (Kraft/Fläche) bezeichnet, die in der Halbleiterschicht entsteht, wenn auf diese eine Zug- oder Druckkraft einwirkt, deren Richtung in der Ebene der Halbleiterschicht liegt. Diese wird in Abhängigkeit von der Richtung der Kraft gespannt oder gestaucht. Diese laterale Spannung ist nicht gleich der sogenannten Schubspannung, die eine sogenannte Scherung in einen Körper erzeugt.

Diese laterale mechanische Spannung ist in einem Supergitter einstellbar durch die Wahl der Gitterkonstanten in den einzelnen einkristallinen Halbleiterschichten. Wird beispielsweise ausgegangen von einem Substrat, das im wesentlichen aus einer Atomart besteht, z. B. ein Si-Substrat mit einer (100)-Kristallorientierung, so hat dieses Si-Substrat eine natürliche (100)-Gitterkonstante von 0,543 nm. Wird nun auf dieses Si-Substrat beispielsweise eine $Si_{0.5}Ge0,5$-Halbleiterschicht in einem Molekularstrahlepitaxie (MBE)-Verfahren aufgewachsen, so hat die unmittelbar an das Si-Substrat angrenzende Schicht der $Si_{0.5}Ge_{0.5}$-Schicht die gleiche Gitterkonstante in lateraler Richtung wie das darunter liegende einkristalline Silizium. Man nennt dies pseudomorphes Wachstum einer heteroepitaxialen Schicht. Erst oberhalb einer sognannten kritischen Schichtdicke verändert sich die Gitterkonstante in lateraler Richtung der $Si_{0.5}Ge_{0.5}$-Schicht durch Fehlanpassungsversetzungen auf ihre natürliche Gitterkonstante von 0,554 nm.

Eine Schicht mit einer Schichtdicke, die kleiner als die kritische Schichtdicke ist, wird auch als unterkritische Schicht bezeichnet. Eine Schicht mit einer Schichtdicke, die größer als die kritische Schichtdicke ist, wird auch als überkritische Schicht bezeichnet. Dabei ist die kritische Schichtdicke von dem Material der Halbleiterschicht abhängig.

Wird nun beispielsweise auf einem Si-Substrat eine $Si_{0.5}Ge_{0.5}$Schicht mit einer unterkritischen Schichtdicke abgeschieden, so entsteht in der $Si_{0.5}Ge_{0.5}$Schicht eine laterale mechanische (Druck- )Spannung, da die natürliche Gitterkonstante von einkristallinem $Si_{0.5}Ge_{0.5}$ größer ist als diejenige von einkristallinem Si. Auf diese Art und Weise ist es möglich, in der HalbleiterSchichtenfolge eines Supergitters unterschiedliche laterale Zug- oder Druckspannungen zu erzeugen, welche die Elektronenbeweglichkeit beeinflussen.

Beispielsweise ist es möglich, auf einem Si-Substrat mit einer (100)Kristallorientierung und einer natürlichen Gitterkonstanten von 0,543 nm zunächst eine erste Zwischenschicht aus einkristallinem $Si_{0.75}Ge_{0.25}$ abzuscheiden. Diese erste Zwischenschicht hat eine überkritische Schichtdicke von ungefähr 0,2 µm. Auf dieser ersten Zwischenschicht werden nun zehn Halbleiterschichten eines Si-SiGe-Supergitters abgeschieden, bestehend aus einer alternierenden Folge aus einer einkristallinen Si-Schicht mit einer unterkritischen Schichtdicke von beispielsweise 5 nm und einer einkristallinen $Si_{0.5}Ge_{0.5}$-Schicht mit einer unterkritischen Schichtdicke von ebenfalls beispielsweise 5 nm. Dadurch entsteht in der Si-Schicht eine laterale Zugspannung, während in der $Si_{0.5}Ge_{0.5}$ -Schicht eine laterale Druckspannung entsteht.

Weiterhin ist es möglich, die Zusammensetzung des Substrates und/oder der Zwischenschicht so zu wählen, daß diese eine Gitterkonstante besitzen, welche in der darauf abgeschiedenen unterkritischen Halbleiter-Schichtenfolge des Supergitters die erwünschten lateralen mechanischen Spannungen erzeugt.

Außerdem ist es möglich, innerhalb der Halbleiterschichtenfolge des Supergitters den mechanischen Spannungszustand zu ändern. Dieses ist mit Hilfe einer zweiten Halbleiter-Zwischenschicht möglich. Wird beispielsweise auf der erwähnten ersten Zwischenschicht ein Supergitter ab geschieden, bestehend aus einer alternierenden Folge von zwei unterkritischen Si-Schichten und zwei unterkritischen $Si_{0.5}Ge_{0.5}$-Schichten, so entstehen in diesen die erwähnten lateralen mechanischen Druck- und Zugspannungen. Wird nun auf diesem Si-$Si_{0.5}Ge_{0.5}$-Supergitter eine einkritalline zweite Zwischenschicht abgeschieden, z. B. eine einkristalline überkritische SiSchicht, so kann auf dieser zweiten Zwischenschicht beispielsweise ein Supergitter abgeschieden werden, das aus einer Halbleiter-Schichtenfolge aus jeweils einer einkristallinen unterkritischen $Si_{0.75}Ge_{0.25}$Schicht und einer einkristallinen unterkritischen SiSchicht besteht. Es entstehen zwei Supergitter, deren mechanische Spannungszustände durch die zweite Zwischenschicht entkoppelt sind oder in vorherbestimmbarer Weise koppelbar sind.

Eine zusätzliche Dotierung, z. B. mit Antimon, der Halbleiterschichten des Supergitters ist mit dem Verfahren der Dotierstoff-Sekundärimplantation möglich, das in der nichtvorveröffentlichten deutschen Patentanmeldung P 3 442 460.1 beschrieben ist.

**Patentansprüche:**

1. Verfahren zur Herstellung einer räumlich periodischen Halbleiter-Schichtenfolge, die als Supergitter ausgebildet wird durch eine alternierende Anordnung von mindestens zwei unterschiedlichen Halbleiterschichten, die mindestens einen Heteroübergang bilden und die aus Si- und SiGe-Schichten, insbesondere aus epitaktisch gewachsenen Si- und SiGe-Schichten bestehen, *dadurch gekennzeichnet*

- daß während eines Epitaxie-Prozesses lediglich in SiGe-Schichten und zwar in mindestens einer SiGe-Schicht eine dotierte Schicht erzeugt wird, die im wesentlichen parallel zum Heteroübergang verläuft und deren Schichtdicke kleiner oder gleich der SiGe-Schicht ist, und
- daß die Dicken der Halbleiterschichten und die Zusammensetzung der SiGe-Schichten derart gewählt werden, daß die SiGe-Schichten eine Gitterkonstante besitzen, so
- daß mindestens eine der Halbleiterschichten des Heteroübergangs des Supergitters mit einer unterkritischen Schichtdicke epitaktisch gewachsen wird.

2. Verfahren zur Herstellung einer räumlich periodischen Halbleiter-Schichtenfolge nach Anspruch 1, dadurch gekennzeichnet, daß mehrere dotierte Schichten räumlich periodisch in der Halbleiter-Schichtenfolge angeordnet werden mit einer Periodizität, welche derjenigen der HalbleiterSchichtenfolge entspricht.

3. Verfahren zur Herstellung einer räumlich periodischen Halbleiter-Schichtenfolge nach Anspruch 1 oder Anspruch 2, dadurch gekennzeichnet,

- daß bei einer Halbleiter-Schichtenfolge aus Siund SiGe-Schichten mindestens eine dotierte Schicht in mindestens einer SiGe-Schicht erzeugt wird, und
- daß zum Erzeugen der dotierten Schicht ein Element der fünften Gruppe des periodischen Systems der Elemente verwendet wird.

4. Verfahren zur Herstellung einer räumlich periodischen Halbleiter-Schichtenfolge nach einem der vorhergehenden Ansprüche, dadurch gekennzeichnet, daß zum Erzeugen der dotierten Schicht das Element Antimon verwendet wird.

5. Verfahren zur Herstellung einer räumlich periodischen Halbleiter-Schichtenfolge nach einem der vorhergehenden Ansprüche, dadurch gekennzeichnet, daß die Halbleiterschichtenfolge sowie deren Dotierung durch ein Molekularstrahlepitaxie-Verfahren erzeugt werden.

6. Verfahren zur Herstellung einer räumlich periodischen Halbleiter-Schichtenfolge nach einem der vorhergehenden Ansprüche, dadurch gekennzeichnet,

- daß die Halbleiter-Schichtenfolge des Supergitters auf einem einkristallinen Substrat aufgebracht wird,
- daß mindestens eine Halbleiterschicht des Supergitters mit einer dem Substrat entsprechenden Zusammensetzung hergestellt wird, und
- daß mindestens eine andere Halbleiterschicht des Supergitters mit einer unterkritischen Schichtdicke epitaktisch gewachsen wird.

7. Verfahren zur Herstellung einer räumlich periodischen Halbleiter-Schichtenfolge nach einem der vorhergehenden Ansprüche 1 bis 5, dadurch gekennzeichnet,

- daß die Halbleiter-Schichtenfolge des Supergitters auf einem als Mischkristall ausgebildeten Substrat aufgebracht wird,
- daß die Halbleiterschichten des Supergitters nicht mit einer dem Substrat entsprechenden Zusammensetzung hergestellt werden, und
- daß die Halbleiterschichten des Supergitters mit einer unterkritischen Schichtdicke epitaktisch gewachsen werden.

8. Verfahren zur Herstellung einer räumlich periodischen Halbleiter-Schichtenfolge nach einem der vorhergehenden Ansprüche, dadurch gekennzeichnet,

- daß ein einkristallines Substrat verwendet wird, das Si-Atome enthält, und
- daß darauf ein Supergitter aufgebracht wird, das mindestens eine SiGe-Schicht enthält und bei dem zumindest die SiGe-Schicht eine unterkritische Schichtdicke besitzt.

9. Verfahren zur Herstellung einer räumlich periodischen Halbleiter-Schichtenfolge nach einem der vorhergehenden Ansprüche, dadurch gekennzeichnet,

- daß auf einem einkristallinen Substrat eine erste einkristalline Zwischenschicht aufgebracht wird,
- daß auf die erste Zwischenschicht ein Supergitter aufgebracht wird, bestehend aus einer alternierenden Halbleiter-Schichtenfolge,
- daß die erste Zwischenschicht aus einem Halbleiter material hergestellt wird, dessen Gitterkonstante zwischen denjenigen Gitterkonstanten der Halbleiterschichten der Schichtenfolge des Supergitters liegt, und
- daß die erste Zwischenschicht mit einer überkritischen Schichtdicke epitaktisch gewachsen wird.

7

10. Verfahren zur Herstellung einer räumlich periodischen Halbleiter-Schichtenfolge nach Anspruch 9, dadurch gekennzeichnet,

- daß mit einem einkristallinem Si-Substrat eine erste Zwischenschicht aus einem SiGe-Mischkristall mit einer überkritischen Schichtdicke aufgebracht wird, und
- daß auf der ersten Zwischenschicht ein Si-Si-Ge-Supergitter epitaktisch aufgewachsen wird, dessen einzelne Halbleiterschichten jeweils eine unterkritische Schichtdicke besitzen.

11. Verfahren zur Herstellung einer räumlich periodischen Halbleiter-Schichtenfolge nach Anspruch 9, dadurch gekennzeichnet,

- daß das Supergitter aus alternierend angeordneten Si- und SiGe-Schichten aufgebaut wird,
- daß zumindest ein Teil der Halbleiterschichten des Supergitters auf einer zweiten überkritischen einkristallinen Si-Zwischenschicht aufgebaut wird, deren Gitterkonstante zwischen derjenigen der SiSchicht und derjenigen der SiGe-Schicht des Supergitters liegt, und
- daß die Halbleiterschichten des Supergitters jeweils mit einer unterkritischen Schichtdicke epitaktisch aufgewachsen werden.

12. Verfahren zur Herstellung einer räumlich periodischen Halbleiter-Schichtenfolge nach einem der vorhergehenden Ansprüche, *dadurch gekennzeichnet,* daß zumindest eine SiGe-Schicht des Supergitters durch das Verfahren der Dotierstoff-Sekundärimplantation dotiert wird.

## Claims

1. Method for the production of a spatially periodic semiconductor layer sequence which is constructed as supergrating by an alternating arrangement of at least two different semiconductor layers which form a heterotransition and consist of layers of Si and SiGe, in particular of layers of Si and SiGe grown epitaxially, characterised thereby,

- that a doped layer, which extends substantially parallelly to the heterotransition and the layer thickness of which is smaller than or equal to the SiGe layer, is produced merely in SiGe layers and namely in at least one SiGe layer during an epitaxial process and
- that the thickness of the semiconductor layers and the composition of the SiGe layers are so chosen that the SiGe layers possess a grating constant so that at least one of the semiconductor layers of the heterotransition of the supergrating is grown epitaxially with a less than critical layer thickness.

8

2. Method for the production of a spatially periodic semiconductor layer sequence according to claim 1, characterised thereby, that several doped layers are arranged spatially periodically in the semiconductor layer sequence with a periodicity which corresponds to that of the semiconductor layer sequence.

3. Method for the production of a spatially periodic semiconductor layer sequence according to claim 1 or claim.2, characterised thereby,

- that at least one doped layer is produced in at least one SiGe layer in a semiconductor layer sequence of layers of Si and SiGe and
- an element of the fifth group of the periodic system of the elements is used for the production of the doped layer.

4. Method for the production of a spatially periodic semiconductor layer sequence according to one of the preceding claims, characterised thereby, that the element antimony is used for the production of the doped layer.

5. Method for the production of a spatially periodic semiconductor layer sequence according to one of the preceding claims, characterised thereby, that the semiconductor layer sequence as well as its doping are produced by a molecular beam epitaxial process.

6. Method for the production of a spatially periodic semiconductor layer sequence according to one of the preceding claims, characterised thereby,

- that the semiconductor layer sequence of the supergrating is applied onto a monocrystalline substrate,
- that at least one semiconductor layer of the supergrating is produced with a composition corresponding to the substrate and
- that at least one other semiconductor layer of the supergrating is grown epitaxially with a less than critical layer thickness.

7. Method for the production of a spatially periodic semiconductor layer sequence according to one of the preceding claims 1 to 5, characterised thereby,

- that the semiconductor layer sequence of the supergrating is applied on a substrate formed as mixed crystal,
- that the semiconductor layers of the supergrating are not produced with a composition corresponding to the substrate and
- that the semiconductor layers of the supergrating are grown epitaxially with a less than critical layer thickness.

8. Method for the production of a spatially periodic semiconductor layer sequence according to one of the preceding claims, characterised there-

9

by,

- that a monocrystalline substrate is used, which contains Si atoms, and
- that a supergrating is applied thereon, which contains at least one SiGe layer and in which at least the SiGe layer has a less than critical layer thickness.

9. Method for the production of a spatially periodic semiconductor layer sequence according to one of the preceding claims, characterised thereby,

- that a first monocrystalline intermediate layer is applied onto a monocrystalline substrate,
- that a supergrating consisting of an alternating semiconductor layer sequence is applied onto the first intermediate layer,
- that the first intermediate layer is made of a semiconductor material, the grating constant of which lies between those grating constants of the semiconductor layers of the layer sequence of the supergrating, and
- that the first intermediate layer is grown epitaxially with a more than critical layer thickness.

10. Method for the production of a spatially periodic semiconductor layer sequence according to claim 9, characterised thereby,

- that a first intermediate layer of an SiGe mixed crystal is applied with a more than critical layer thickness onto a monocrystralline substrate and
- that an Si-SiGe supergrating, the individual semiconductor layers of which each have a less than critical layer thickness, is grown epitaxially onto the first intermediate layer.

11. Method for the production of a spatially periodic semiconductor layer sequence according to claim 9, characterised thereby,

- that the supergrating is built up of layers of Si and SiGe arranged in alternation,
- that at least a part of the semiconductor layers of the supergrating is built up on a second more than critical monocrystalline Si intermediate layer, the grating constant of which lies between that of the Si layer and that of the SiGe layer of the supergrating, and
- that the semiconductor layers of the supergrating are each grown epitaxially with a less than critical layer thickness.

12. Method for the production of a spatially periodic semiconductor layer sequence according to one of the preceding claims, characterised thereby, that at least one SiGe layer of the supergrating is doped by the method of the secondary implantation of the doping substance.

10

Revendications

1. Procédé de fabrication d'une succession de couches semi-conductrices à périodicité spatiale qui est conçue sous forme de superréseau par une disposition alternée d'au moins deux couches semi-conductrices différentes qui forment au moins une hétérotransition et qui sont constituées de couches Si et SiGe, en particulier de couches Si et SiGe qui ont crû par épitaxie, caractérisé,

- en ce qu'au cours d'un processus d'épitaxie, on crée, uniquement dans les couches SiGe, et, de façon plus précise, dans au moins une couche SiGe, une couche dopée dont la direction est sensiblement parallèle à l'hétérotransition et dont l'épaisseur de couche est inférieure ou égale à celle de la couche SiGe, et
- en ce que l'on choisit les épaisseurs des couches semi-conductrices et la composition des couches SiGe de façon telle que les couches SiGe possèdent une constante de réseau, de sorte qu'au moins l'une des couches semi-conductrices de l'hétérotransition du superréseau a crû par épitaxie avec une épaisseur de couche sous-critique.

2. Procédé de fabrication d'une succession de couches semi-conductrices à périodicité spatiale selon la revendication 1, caractérisé en ce que plusieurs couches dopées sont disposées, avec une périodicité spatiale, dans la succession de couches semi-conductrices, avec une périodicité qui correspond à celle de la succession de couches semi-conductrices.

3. Procédé de fabrication d'une succession de couches semi-conductrices à périodicité spatiale selon la revendication 1 ou la revendication 2, caractérisé,

- en ce que, dans le cas d'une succession de couches semi-conductrices constituées de couches Si et SiGe, on crée une couche dopée dans au moins une couche SiGe et
- en ce que pour créer la couche dopée, on emploie un élément du cinquième groupe du système périodique des éléments.

4. Procédé de fabrication d'une succession de couches semi-conductrices à périodicité spatiale selon l'une des revendications précédentes, caractérisé en ce que pour créer la couche dopée, on emploie l'élément antimoine.

5. Procédé de fabrication d'une succession de couches semi-conductrices à périodicité spatiale selon l'une des revendications précédentes, caractérisé en ce que l'on crée la succession de couches semi-conductrices, ainsi que leur dopage par un procédé par épitaxie par faisceau moléculaire.

6. Procédé de fabrication d'une succession de couches semi-conductrices à périodicité spatiale selon l'une des revendications précédentes, caractérisé

- en ce que l'on rapporte la succession de couches semi-conductrices du superréseau sur un substrat monocristallin,
- en ce que l'on fabrique au moins une couche semi-conductrice du superréseau avec une composition correspondant à celle du substrat et
- en ce que l'on fait croître au moins une autre couche semi-conductrice du superréseau par épitaxie avec une épaisseur de couche sous-critique.

7. Procédé de fabrication d'une succession de couches semi-conductrices à périodicité spatiale selon l'une des revendications précédentes 1 à 5, caractérisé,

- en ce que l'on rapporte la succession de couches semi-conductrices du superréseau sur un substrat formé d'un cristal mixte,
- en ce que l'on ne fabrique pas les couches semi-conductrices du superréseau avec une composition correspondant à celle du substrat et
- en ce que l'on fait croître les couches semi-conductrices du superréseau par épitaxie avec une épaisseur de couche sous-critique.

8. Procédé de fabrication d'une succession de couches semi-conductrices à périodicité spatiale selon l'une des revendications précédentes, caractérisé,

- en ce que l'on emploie un substrat monocristallin qui contient l'atome Si, et
- en ce que l'on rapporte sur ce substrat un superréseau qui contient au moins une couche SiGe et dans le cas duquel au moins la couche SiGe possède une épaisseur de couche sous-critique.

9. Procédé de fabrication d'une succession de couches semi-conductrices à périodicité spatiale selon l'une des revendications précédentes, caractérisé,

- en ce que l'on rapporte sur un substrat monocristallin une première couche intermédiaire monocristalline,
- en ce que sur la première couche intermédiaire on rapporte un superréseau constitué d'une succession alternée de couches semi-conductrices,
- en ce que l'on fabrique la première couche intermédiaire en un matériau semi-conducteur dont la constante de réseau se situe entre les constantes de réseau des couches semi-conductrices de la succession de couches du superréseau et,

- en ce que l'on fait croître la première couche intermédiaire par épitaxie avec une épaisseur de couche surcritique.

10. Procédé de fabrication d'une succession de couches semi-conductrices à périodicité spatiale selon la revendication 9, caractérisé,

- en ce que l'on rapporte sur un substrat Si monocristallin une première couche intermédiaire constituée d'un cristal mixte SiGe, avec une épaisseur de couche surcritique, et
- en ce que sur la première couche intermédiaire on fait croître par épitaxie un superréseau SiGe dont les différentes couches semi-conductrices présentent respectivement une épaisseur de couche sous-critique.

11. Procédé de fabrication d'une succession de couches semi-conductrices à périodicité spatiale selon la revendication 9, caractérisé,

- en ce que le superréseau est constitué de couches Si et SiGe alternativement disposées et en ce que l'on construit au moins une partie des couches semi-conductrices du superréseau sur une seconde couche intermédiaire Si monocristalline surcritique, dont la constante de réseau se situe entre celle de la couche Si et celle de la couche SiGe du superréseau et,
- en ce que l'on fait croître les couches semi-conductrices du superréseau par épitaxie, chacune avec une épaisseur de couche sous-critique.

12. Procédé de fabrication d'une succession de couches semi-conductrices à périodicité spatiale selon l'une des revendications précédentes, caractérisé en ce que l'on dope au moins une couche SiGe du superréseau par le procédé de l'implantation secondaire du produit de dopage.

FIG. 1

FIG. 2